# EUROPÄISCHE PATENTSCHRIFT

(11) **EP 1 281 205 B1**
(45) Veröffentlichungstag und Bekanntmachung des Hinweises auf die Patenterteilung: **06.02.2008**
(21) Anmeldenummer: 01947151.5
(22) Anmeldetag: 11.05.2001
(51) Int. Cl.: H01L 31/0203, H01L 31/0232, H01L 33/00

(54) **OPTOELEKTRONISCHES BAUELEMENT UND VERFAHREN ZUR HERSTELLUNG**
OPTOELECTRONIC COMPONENT AND METHOD FOR THE PRODUCTION THEREOF
COMPOSANT OPTOELECTRONIQUE ET PROCEDE DE FABRICATION DUDIT COMPOSANT

(30) Priorität: 12.05.2000 DE 10023353
(43) Veröffentlichungstag der Anmeldung: 05.02.2003
(73) Patentinhaber: Osram Opto Semiconductors GmbH, 93049 Regensburg (DE)
(72) Erfinder: HÖHN, Klaus, 82024 Taufkirchen (DE); SORG, Jörg, 93080 Pentling (DE)
(74) Vertreter: Epping - Hermann - Fischer
(86) Internationale Anmeldenummer: PCT/DE2001/001820
(87) Internationale Veröffentlichungsnummer: WO 2001/086730

(56) Entgegenhaltungen:
- EP-A- 0 635 744
- EP-A- 0 911 886
- DE-A- 19 918 370
- US-A- 4 727 457
- US-A- 5 450 513
- PATENT ABSTRACTS OF JAPAN vol. 2000, no. 07, 29. September 2000 (2000-09-29) & JP 2000 111721 A (FUJI ELECTRIC CO LTD), 21. April 2000 (2000-04-21) & GB 2 344 346 A (FUJI ELECTRIC COMPANY LTD) 7. Juni 2000 (2000-06-07)
- PATENT ABSTRACTS OF JAPAN vol. 016, no. 158 (E-1191), 17. April 1992 (1992-04-17) & JP 04 010670 A (TOYODA GOSEI CO LTD;OTHERS: 01), 14. Januar 1992 (1992-01-14)
- PATENT ABSTRACTS OF JAPAN vol. 011, no. 249 (E-532), 13. August 1987 (1987-08-13) & JP 62 060277 A (TOSHIBA CORP), 16. März 1987 (1987-03-16)

## Beschreibung

Die Erfindung betrifft ein optoelektronisches Bauelement mit einem Trägerkörper, auf dem ein optoelektronischer Sender oder Empfänger angeordnet ist, mit einer über dem Sender oder Empfänger aufgebrachten und diesen verkapselnden transparenten Schicht und mit einem über der transparenten Schicht angeordneten optischen Element.

Ein solches Bauelement ist beispielsweise aus der DE 19755734 A1 bekannt. Dort ist ein SMD-montierbares optoelektronisches Bauelement beschrieben, welches auf einem mit einer Ausnehmung versehenen Trägerkörper aufgebaut ist. Der optoelektronische Sender oder Empfänger ist in der Ausnehmung angeordnet und mit einer optisch angepaßten transparenten Kunststoffschicht verkapselt. Über der transparenten Kunststoffschicht und in direktem Kontakt mit dieser ist als optisches Element eine Linse angeordnet, mit deren Hilfe der Lichteinfall oder die Lichtabstrahlung des Bauelements kontrolliert wird. Für die Kunststoffschicht wird eine transparente Vergußmasse verwendet, wobei die Linse vor dem vollständigen Aushärten dieser Vergußmasse auf die Kunststoffschicht aufgesetzt wird. Beim Aushärten der Vergußmasse entsteht sowohl ein guter optischer Kontakt als auch eine gute Haftung zwischen der Kunststoffschicht und der optischen Linse.

Nachteilig an dieser Lösung ist, daß eine genaue Ausrichtung der Linse nur schwierig möglich ist und daß die Linse während des Aushärtens relativ zum Grund- oder Trägerkörper fixiert werden muß. Da diese Fixierung während der gesamten Aushärtezeit, die je nach verwendetem Kunststoff bis zu mehreren Minuten und Stunden erfordern kann, aufrechterhalten werden muß, erschwert dies die Herstellung des optoelektronischen Bauelements.

Bei dem in der Druckschrift US 4,727,457 offenbarten Bauelement wird die Fixierung mittels eines Distanzrings bewerkstelligt.

Die Druckschrift EP 0 911 886 A2 offenbart ein optoelektronisches Bauelement, bei dem ein strahlungsempfangender oder -emittierender Halbleiterchip mit einem Epoxidharz vergossen ist, das eine Linse bildet.

Die Druckschrift EP 0 635 744 A2 beschreibt ein optisches System, bei dem ein LED-Chip mit einer Linse vergossen und die Linse in eine Vertiefung eines äußeren Linsenelements eingeklebt ist.

Aufgabe der vorliegenden Erfindung ist es daher, ein optoelektronisches Bauelement anzugeben, bei dem ein optisches Element wie zum Beispiel Linse einfach und sicher ausgerichtet und fixiert werden kann.

Diese Aufgabe wird erfindungsgemäß durch ein Bauelement der eingangs genannten Art mit Hilfe der Merkmale von Anspruch 1 gelöst. Vorteilhafte Ausgestaltungen der Erfindung sowie ein Verfahren zum passgenauen Verkleben gehen aus weiteren Ansprüchen hervor.

Die Erfindung schlägt vor, das optische Element mit Hilfe der Klebstoffschicht aus einem einkomponentigen Harz auf einer transparenten Schicht aufzukleben. Mit Hilfe der Erfindung ist es möglich, die als transparente Schicht verwendete Kunststoffschicht unabhängig vom optischen Element auszuhärten und gegebenenfalls deren Oberfläche zu behandeln. Das einkomponentige Harz der Klebstoffschicht ermöglicht ein einfaches Aufbringen des optischen Elements auf der transparenten Schicht.

Vorzugsweise wird als Klebstoffschicht ein UV- oder licht-initiiert kationisch gehärtetes Epoxidharz eingesetzt. Harze mit diesem Härtungsmechanismus haben den Vorteil, daß sie in einem schnellen Licht- oder UV-initiiert angeregten Prozeß in eine Gelphase übergehen, die bereits eine Vorfixierung erlaubt. Beim Einsatz eines solchen Harzes als Klebstoff wird also eine schnelle Fixierung der zu verklebenden Teile ermöglicht. Eine vollständige Aushärtung der bereits vorfixierten Teile kann dann in einem weiteren Schritt ohne zusätzliche Hilfsmaßnahmen wie etwaige Fixierungen erfolgen.

Die Anhärtung kann dabei innerhalb weniger Sekunden erfolgen. Möglich ist es sogar, die Anhärtung nur mit Hilfe eines Licht- oder UV-Blitzes anzuregen. Dies ist ausreichend, die zu verklebenden Teile so fest zu fixieren, daß während der vollständigen Aushärtung, die zu einem beliebigen späteren Zeitpunkt stattfinden kann, die Ausrichtung der zu verklebenden Teile relativ zueinander erhalten bleibt. Damit ist eine schnelle und exakte Fixierung der zu verklebenden Teile möglich, was insbesondere bei optischen Systemen wichtig ist.

Die schnelle Anhärtung des kationisch härtenden Harzes hat den weiteren Vorteil, daß sie bei einer beliebigen Temperatur durchgeführt werden kann, die im Hinblick auf die spätere Verwendung der Verklebung und insbesondere im Hinblick auf die spätere Betriebstemperatur des optoelektronischen Bauelements ausgewählt sein kann. Bevorzugt wird die strahleninduzierte Vorhärtung der Klebstoffschicht bei möglichst niedrigen Teperaturen durchgeführt, insbesondere bei Temperaturen bis 60°C. Auf diese Weise können thermische Spannungen vermieden werden, die durch thermische Ausdehnung bei der Härtung bei erhöhter Temperatur in die Klebestelle eingebracht sein können. Eine spannungsreduzierte Verklebung zeichnet sich außerdem durch eine erhöhte Stabilität aus, und läßt sich in reproduzierbarer Weise herstellen. Gegebenenfalls von einer vorhandenen thermomechanischen Verspannung abhängige Materialeigenschaften können so konstant und reproduzierbar eingestellt werden. Dadurch kann auch die vollständige Härtung zu einem beliebigen späteren Zeitpunkt durchgeführt werden.

Der chemische und geometrische Aufbau der Klebstoffschicht ist außerdem so gewählt, daß die Klebstoffschicht unter Temperatur-, Feuchte- und Strahlenbelastung, die bei dem optoelektronischen Bauelement in verstärkter Weise zu berücksichtigen ist, weder vergilbt, noch eintrübt und sich in ihren mechanischen sowie mechanischen Eigenschaften verschlechtert. Damit ist auch gewährleistet, daß weder die Lichtausbeute herabgesetzt, noch die Abstrahlcharakteristik des optoelektronischen Bauelements verändert wird. Auch die mechanische Festigkeit der Klebstoffschicht wird über die genannten Belastungen nicht reduziert. Es kann damit sichergestellt werden, daß die Funktionstüchtigkeit bei der Herstellung, Qualifizierung und während der gesamten Betriebszeit bzw. Lebensdauer von bei LEDs üblichen zehn Jahren gewährleistet wird. Die Klebstoffschicht und damit das optoelektronische Bauelement bzw. die LED bestehen die anspruchsvollen Qualifizierungsanforderungen für den Automobilbereich.

Durch geeignete Auswahl der Harzkomponenten ist es außerdem möglich, ein Harz mit ausreichend hoher Glasübergangstemperatur T_{G} von beispielsweise 120°C und mehr zu erhalten. Dies garantiert einen sicheren Betrieb des mit diesem Harz verklebten Bauelements bei Betriebstemperaturen unterhalb der Glasübergangstemperatur. Diese hohe T_{G} bleibt auch über die Lebensdauer des Bauelements erhalten, ohne sich unter Temperatur-, Licht- oder Feuchtebelastung zu reduzieren.

Nach vollständiger Aushärtung des Harzes zeigt dieses keinerlei optische Inhomogenitäten, weder Lufteinschlüsse noch Cracks, Risse oder etwa eine Delamination. Der Klebstoff und damit auch die Klebeverbindung ist ausreichend temperaturstabil und übersteht Lötbadbedingungen, welche für die SMD-Montage des SMD-Bauelemenst erforderlich sind, schadlos und ohne Funktionsstörungen.

Die ausgehärtete Klebstoffschicht kann auf einen Brechungsindex n_{D} von mehr als 1,50 eingestellt werden. Damit ist sie optisch optimal an die bevorzugt verwendeten optischen Pressmassen angepaßt, die bevorzugt für das optische Element verwendet werden.

Beim Verkleben transparenter Teile, wie bei der vorliegenden Erfindung, gelingt es, bei der Bestrahlung mittels UV oder sichtbarem Licht durch die zu verklebenden Teile hindurch das gesamte Klebstoffschichtvolumen zu erfassen, so daß eine überall gleichmäßig einsetzende (An-)Härtung erfolgt. Dies ist bereits bei geringem Bestrahlungsleistungen von weniger als 100 mW/cm² erreichbar.

Das Harz kann rheologisch so angepaßt werden, daß eine Mikrodosierung bei 60°C mit Dosiertoleranzen von < +/- 3% möglich ist, so daß die Klebstoffschicht in einer dünnen Schichtdicke von beispielsweise bis zu 100 *µ*m exakt und reproduzierbar aufgebracht werden kann, wobei gute Klebeigenschaften der Klebeverbindung erhalten werden. Das Klebeverfahren ist so ausgelegt, daß es in großmaßstäblicher hochautomatisierter Fertigung mit hohen Durchsatzzahlen durchführbar ist. Dies wird insbesondere durch die schnellen Anhärtezeiten erreicht, mit der sich die Linse auf der Kunststoffschicht fixieren läßt.

Für das erfindungsgemäße Bauelement findet bevorzugt ein flüssig applizierbares Epoxidharzsystem Verwendung, welches die folgende in Gewichtsprozent angegebene allgemeine Zusammensetzung aufweisen kann:

| | |
|---|---|
| Di- und mehrfunktionelles Epoxidharz | 80 - 99 % |
| Monofunktionelles Epoxidharz (Reaktivverdünner, Monoglycidylether) | 0 - 10 % |
| (Poly-) Vinylether | 0 - 20 % |
| Aliphatischer oder cycloaliphatischer Alkohol | 0 - 10 % |
| Haftvermittler (Organofunktionelle Alkoxy-Siloxane) | 0 - 5 % |
| Verlaufshilfsmittel, vorzugsweise auf Silikon- oder Acrylatbasis | 0 - 1 % |
| Entlüfter, vorzugsweise auf Silikon- oder Acrylatbasis | 0 - 1 % |
| Katalysator für UV-initiiert kationische Härtung | 0,1 - 2 % |

Als Photoinitiator für die kationische Härtung wird beispielsweise UVI6974 (CIBA SC) eingesetzt. Für die spätere thermische Härtung können noch Initiatoren für eine kationisch initiiert thermische Härtung eingesetzt werden. Bevorzugt werden dabei Halonium- und Oniumsalzes des Schwefels (Sulfoniumsalze) eingesetzt. Ein geeigneter thermische Initiator ist z.B. S-Benzylthiolaniumhexafluorantimonat (Aldrich).

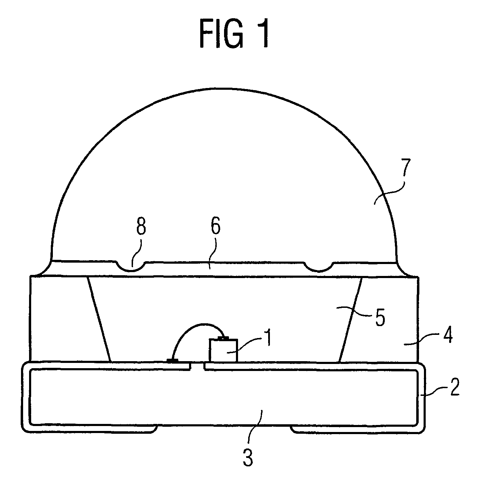

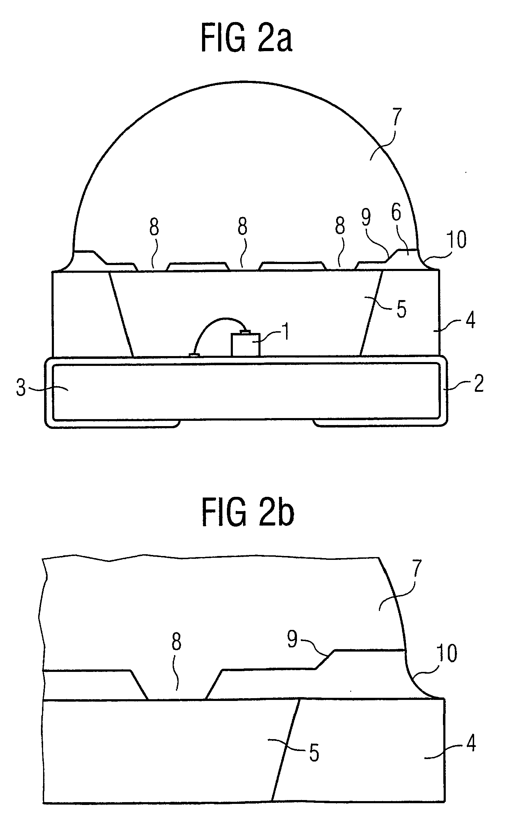

Im folgenden wird die Erfindung anhand von Ausführungsbeispielen in Verbindung mit den Figuren 1 und 2 näher erläutert.

Es zeigen
Figur 1 eine schematische Schnittdarstellung eines ersten Ausführungsbeispiels eines erfindungsgemäßen Bauelements und
Figur 2a und 2b eine schematische Schnittdarstellung bzw. eine Detailansicht eines zweiten Ausführungsbeispiels eines erfindungsgemäßen Bauelements.

Gleiche oder gleichwirkende Elemente sind in den Figuren mit denselben Bezugszeichen versehen.

Der Grundkörper für das in Figur 1 dargestellte Bauelement wird durch Umspritzen eines Leiterbandes 2 mit einem Hochtemperaturthermoplast unter Herausbildung eines Gehäuses 3 gebildet. Das Gehäuse weist in der Mitte eine Ausnehmung auf, in der der optische Sender oder Empfänger angeordnet und mit dem Leiterband, aus dem die SMD-fähigen Kontakte hergestellt sind, elektrisch verbunden wird. Die Ausnehmung im Gehäuse weist vorzugsweise schräge Seitenflächen 4 auf, die daher als Reflektor für das optoelektronische Bauelement dienen können.

Nach der Montage und Kontaktierung des optischen Senders oder Empfängers 1 in der Ausnehmung wird diese mit einer fließfähigen Vergußmasse befüllt, und diese anschließend zu einer den Sender oder Empfänger verkapselnden Kunststoffschicht 5 ausgehärtet. Auf die Kunststoffschicht 5 wird anschließend eine dünne Schicht 6 eines UV-initiiert-kationisch härtenden Epoxidharzes in einer Schichtdicke von beispielsweise 90 *µ*m aufgebracht. Auf diese Harzschicht 6, die die spätere Klebeschicht bildet, wird anschließend als optisches Element die optische Linse 7 aufgesetzt, ausgerichtet und gegebenenfalls in der exakten Position kurz fixiert.

Vorzugsweise sind auf der Fügefläche des optischen Elements Strukturen 8 ausgebildet, die eine bessere mechanische Verzahnung der zu verklebenden Oberflächen ermöglichen. Dies können beispielsweise Zapfen, Noppen oder ähnlich geformt Vorsprünge oder Einbuchtungen sein. Auch eine im Querschnitt sägezahnartige Topologie ist möglich. Solche Strukturen können beispielsweise an die Fügefläche angeformt sein.

Weiterhin kann die Linse oder allgemein das optische Element auf der Fügeseite eine nicht dargestellte Oberflächentopologie aufweisen, die von einer planen Fläche abweicht. Dies kann insbesondere eine definierte Rauhigkeit oder Welligkeit sein.

Zur Ausrichtung der zu verklebenden Teile in exaktem und reproduzierbaren Abstand voneinander ist es vorteilhaft, Abstandselemente oder Spacer zwischen den Fügeflächen anzuordnen. Diese können Teil einer der Fügeflächen und beispielsweise an das optische Element angeformt sein.

Die Linse selbst kann zur gezielten Einstellung der Abstrahlcharakteristik neben der dargestellten konvexen Geometrie außerdem eine planparallele oder eine konkave Abstrahlfläche sowie unterschiedliche Krümmungsradien aufweisen.

Nach der Ausrichtung des optischen Elements wird die gesamte Anordnung für kurze Zeit von oben einer UV-Strahlung ausgesetzt, beispielsweise einem UV-Blitz. Nach wenigen Sekunden, insbesondere nach einer Zeitdauer von 0,1 bis 5 Sekunden ist die optische Linse 7 ausreichend auf der Kunststoffschicht 5 fixiert und die Klebstoffschicht 6 ausreichend angehärtet.

In einem zweiten Schritt wird die Klebeschicht 6 anschließend vollständig ausgehärtet, beispielsweise zwei Stunden lang bei einer Temperatur von 120°C.

Für das erfindungsgemäß verwendete UV-initiiert-kationisch härtende Epoxidharz werden folgende in Gewichtsteilen (pbw) angegebene Zusammensetzungen gewählt.

### Beispiel a)

| | |
|---|---|
| Bisphenol-A-Epoxidgießharz, GY260 | 88,9 pbw |
| Epoxynovolak D.E.N. 438 | 10,9 pbw |
| Tego-DF48 (Haftvermittler) | 0,4 pbw |
| Initiator UVI6974 | 1,0 pbw |

### Beispiel b)

| | |
|---|---|
| Bisphenol-A-Epoxidgießharz GY260 | 88,9 pbw |
| Epoxynovolak D.E.N. 438 | 10,0 pbw |
| BYKA506 | 0,4 pbw |
| Intiator UVI6974 | 0,7 pbw |

Mit den beiden Epoxidharzzusammensetzungen a und b werden optoelektronische Bauelemente mit Klebeschichten erhalten, die unter den möglichen Einsatzbedingungen des Bauelements gegen Temperatur-, Feuchte- und Strahlenbelastung so stabil sind, daß sie weder eine Vergilbung, Eintrübung oder sonstige Veränderung aufweisen, die die Lichtausbeute herabsetzen oder die Abstrahlcharakteristik verändern könnten. Die Harzzusammensetzungen sind innerhalb weniger Sekunden anhärtbar und zeigen nach vollständiger Aushärtung eines ausreichend Haftfestigkeit. Sie überstehen Lötbadbedingungen von 3 x 260°C schadlos und ohne Verminderung der thermomechanischen Eigenschaften der Klebstoffschicht.

Eine weitere, nicht in den Ausführungsbeispielen beschriebene Modifikation betrifft die Zugabe einer bestimmten Menge an Vinylethern, mit deren Hilfe die Anhärtzeit weiter verkürzt werden kann. Damit ist es möglich, die Anhärtung zu beschleunigen und damit den Durchsatz bei der Herstellung der optoelektronischen Bauelemente weiter zu erhöhen. Die übrigen Bestandteile können außerdem so ausgewählt sein, daß sie optimal optisch an die Kunststoffschicht angepaßt sind, so daß keine optischen Verluste beim Übergang von der Kunststoffschicht in die Klebstoffschicht oder beim Übergang von der Klebstoffschicht in die Linse in Kauf genommen werden müssen.

In Figur 2 ist ein weiteres Ausführungsbeispiel eines erfindungsgemäßen Bauelements im Schnitt schematisch dargestellt.

Im Unterschied zu dem ersten Ausführungsbeispiel weist die Linse 7 auf der Fügeseite eine Anschrägung 9 auf, so daß sich der Klebespalt zum Rand des Bauelements hin erweitert. Diese Anschrägung 9 kann beispielsweise auch als umlaufende Fase an der Fügeseite des optischen Elements ausgebildet sein.

Durch diese Formgebung wird ein Reservoir für überschüssigen Klebstoff geschaffen. Der Klebstoff bildet randseitig aufgrund seiner Oberflächenspannung eine Hohlkehle 10 aus, wie in der Detailansicht in Figur 2b genauer dargestellt ist. Mit Vorteil wird dadurch die Gefahr, daß überschüssiger Klebstoff auf die Gehäuseseitenwände gelangt, verringert. Zudem werden auch die Anforderungen an die Dosiergenauigkeit des Klebstoffs gesenkt.

An die Fügefläche des optischen Elements sind zapfenartige Strukturen 8 angeformt, die als Abstandshalter zwischen Linse 7 und Kunststoffschicht 5 dienen. Dadurch wird eine definierte und gleichbleibende Dicke der Klebeschicht 6 gewährleistet. Zugleich bilden diese Abstandshalter 8 eine Verzahnung zwischen der Klebeschicht 6 und der Linse aus, die die Festigkeit der Klebeverbindung erhöht.

Die Erläuterung der Erfindung anhand der beschriebenen Ausführungsbeispiele ist selbstverständlich nicht an Beschränkung der Erfindung auf diese zu verstehen.

## Patentansprüche

1. Optoelektronisches Bauelement
mit einem optoelektronischen Sender oder Empfänger (1),
mit einer über dem Sender oder Empfänger aufgebrachten und diesen verkapselnden transparenten Schicht (5),
mit einem über der transparenten Schicht angeordneten optischen Element (7),
**dadurch gekennzeichnet,**
**daß** das optoelektronische Bauelement ein Gehäuse (3) mit einer Ausnehmung aufweist,
**daß** der optoelektronische Sender oder Empfänger in der Ausnehmung montiert ist und die transparente Schicht in der Ausnehmung angeordnet ist und
**daß** das optische Element mit einer von der transparenten Schicht verschiedenen Klebstoffschicht (6) aus einem einkomponentigen Harz auf die transparente Schicht aufgeklebt ist.

2. Bauelement nach Anspruch 1,
bei dem die Klebstoffschicht (6) ein UV- oder Licht-initiiert kationisch gehärtetes Epoxidharz ist.

3. Bauelement nach Anspruch 1 oder 2,
bei dem die Klebstoffschicht (6) eine Glasübergangstemperatur von mehr als 100°C aufweist.

4. Bauelement nach einem der Ansprüche 1 bis 3,
bei dem die Klebstoffschicht (6) einen Brechungsindex von mehr als 1,5 aufweist.

5. Bauelement nach einem der Ansprüche 1 bis 4,
bei dem transparente Schicht (5) und optisches Element (7) aus Glas, Polyacrylat, Polyurethan oder Epoxidharzformstoff bestehen.

6. Bauelement nach einem der Ansprüche 1 bis 5,
bei dem das optische Element (7) auf der Fügefläche eine Oberflächentopologie aufweist, die von einer planen Fläche abweicht.

7. Bauelement nach einem der Ansprüche 1 bis 6,
bei dem auf der Fügeseite des optischen Elementes (5) eine Verzahnung (8) ausgebildet ist.

8. Bauelement nach Anspruch 7,
bei dem die Verzahnung (8) durch Einbuchtungen oder Vorsprünge, insbesondere in Form von an das optische Element (5) angeformten noppen- oder zapfenartigen Strukturen, ausgebildet ist.

9. Bauelement nach einem der Ansprüche 1 bis 8,
bei dem zwischen dem optischen Element (5) und der transparenten Schicht (6) Abstandselemente (8) angeordnet und vorzugsweise an das optische Element angeformt sind.

10. Verfahren zum paßgenauen Verkleben transparenter Teile (5, 7) eines optoelektronischen Bauelements mit den Schritten:
- Auftragen einer dünnen Harzschicht (6) eines kationisch initiiert härtbaren Epoxidharzes auf eine Oberfläche eines der zu verklebenden transparenten Teile,
- Aufsetzen und Ausrichten eines weiteren transparenten Teils auf die Harzschicht
- Beaufschlagung mit UV oder Licht-Strahlung zur Anhärtung der Harzschicht
- Vollständiges Aushärten der Harzschicht, wobei
- die Harzschicht von dem transparenten Teil und dem weiteren transparenten Teil verschieden ist ,
- eines der transparenten Teile eine über einem optoelektronischen Sender oder Empfänger (1) aufgebrachte und diesen verkapselnde transparente Schicht (5) ist, die in einer Ausnehmung eines Gehäuses des optoelektronischen Bauelements (3), in welcher der Sender oder Empfänger montiert ist, angeordnet ist, und
- das andere transparente Teil ein optisches Element (7) ist.

11. Verfahren nach Anspruch 10, bei dem eines der zu verklebenden Teile (5) durch Aushärten einer Vergussmasse hergestellt wird, wobei die Vergussmasse ausgehärtet wird, bevor die Harzschicht (6) aufgetragen und das weitere transparente Teil (7) aufgesetzt und ausgerichtet wird.

12. Verfahren nach einem der Ansprüche 10 bis 11,
bei dem die Beaufschlagung mit UV Strahlung durch einen UV-Blitz und die Aushärtung bei Temperaturen oberhalb 120°C erfolgt.

13. Verfahren nach einem der Ansprüche 10 bis 12,
bei dem für die Harzschicht (6) ein Epoxidharz mit einem Diglycidylether von Bisphenol A als Hauptbestandteil und einem Kationen freisetzenden Photoinitiator eingesetzt wird.

14. Verfahren nach Anspruch 13,
bei dem ein Epoxidharz eingesetzt wird, das folgende in Gewichtsprozent angegebene Bestandteile umfaßt:
80 bis 99% Di- und mehrfunktionelle Epoxidharze
0 bis 10% monofunktionelles Epoxidharz
0-19% Vinylether
0-10% aliphatischer oder cycloaliphatischer Alkohol
0-5% Haftvermittler
0,1-5% Photoinitiator für kationisch initiierte Härtung

15. Verwendung eines kationisch initiiert härtbaren Epoxidharzes mit einem Diglycidylether von Bisphenol A als Hauptbestandteil zum positionsgenauen Verkleben einer über einem optoelektronischen Sender oder Empfänger (1) aufgebrachten und diesen verkapselnden transparenten Schicht (5), die in einer Ausnehmung eines Gehäuses eines optoelektronischen Bauelements (3), in welcher der Sender oder Empfänger montiert ist, angeordnet ist, mit einem weiteren optischen Element (7) wie einem Spiegel oder einer Linse.

16. Verwendung nach Anspruch 15 zur zuverlässigen Verklebung folgender Materialkombinationen von Fügepartnern: Kunststoff/Kunststoff, Kunststoff/Glas, Glas/Glas.

17. Verwendung nach Anspruch 16 zur funktionssicheren Verklebung SMD fähiger optoelektronischer Bauelemente für den Automobilbereich.

## Claims

1. Opto-electronic component
having an opto-electronic transmitter or receiver (1),
having a transparent layer (5) applied over the transmitter or receiver and encapsulating it,
having an optical element (7) arranged over the transparent layer,
**characterized**
**in that** the opto-electronic component has a housing (3) with a recess,
**in that** the opto-electronic transmitter or receiver is mounted in the recess, and the transparent layer is arranged in the recess, and
**in that** the optical element is bonded to the transparent layer by means of an adhesive layer (6) which is different from the transparent layer and which comprises a single-component resin.

2. Component according to Claim 1,
in which the adhesive layer (6) is an epoxy resin cationically cured under UV or light initiation.

3. Component according to Claim 1 or 2,
in which the adhesive layer (6) has a glass transition temperature of more than 100°C.

4. Component according to one of Claims 1 to 3,
in which the adhesive layer (6) has a refractive index of more than 1.5.

5. Component according to one of Claims 1 to 4,
in which the transparent layer (5) and the optical element (7) are made of glass, polyacrylate, polyurethane or epoxy resin moulding material.

6. Component according to one of Claims 1 to 5,
in which the optical element (7) has, on the joint face, a surface topology which differs from a planar face.

7. Component according to one of Claims 1 to 6,
in which a tooth arrangement (8) is formed on the joint side of the optical element (5).

8. Component according to Claim 7,
in which the tooth arrangement (8) is formed by niches or projections, particularly in the form of nub-like or lug-like structures formed onto the optical element (5).

9. Component according to one of Claims 1 to 8,
in which the optical element (5) and the transparent layer (6) have spacing elements (8) arranged between them and preferably formed onto the optical element.

10. Method for bonding transparent parts (5, 7) of an opto-electronic component with an accurate fit, having the following steps:
- a thin resin layer (6) of an epoxy resin which can be cured under cationic initiation is applied to a surface of one of the transparent parts to be bonded,
- a further transparent part is put and oriented onto the resin layer,
- UV or light radiation is applied for the purpose of initially curing the resin layer,
- the resin layer is cured completely, wherein
- the resin layer is different from the transparent part and the further transparent part,
- one of the transparent parts is a transparent layer (5) which is applied over an opto-electronic transmitter or receiver (1) and encapsulates it and which is arranged in a recess in a housing of the opto-electronic component (3), in which recess the transmitter or receiver is mounted, and
- the other transparent part is an optical element (7).

11. Method according to Claim 10, in which one of the parts (5) to be bonded is produced by completely curing a potting compound, the potting compound being cured completely before the resin layer (6) is applied and the further transparent part (7) is put on and oriented.

12. Method according to one of Claims 10 to 11,
in which the UV radiation is applied using a UV flash, and the complete curing takes place at temperatures above 120°C.

13. Method according to one of Claims 10 to 12,
in which an epoxy resin with a diglycidyl ether of bisphenol A as primary constituent and a photoinitiator releasing cations is used for the resin layer (6).

14. Method according to Claim 13,
in which an epoxy resin is used which comprises the following constituents, indicated in percentage by weight:
80 to 99% difunctional and multifunctional epoxy resins
0 to 10% monofunctional epoxy resin
0-19% vinyl ether
0-10% aliphatic or cycloaliphatic alcohol
0-5% adhesion promoter
0.1-5% photoinitiator for cationically initiated curing.

15. Use of an epoxy resin which can be cured under cationic initiation with a diglycidyl ether of bisphenol A as primary constituent for bonding a transparent layer (5) which is applied over an opto-electronic transmitter or receiver (1) and encapsulates it and which is arranged in a recess in a housing of an opto-electronic component (8), in which recess the transmitter or receiver is mounted, in an accurate position to a further optical element (7), such as a mirror or a lens.

16. Use according to Claim 15 for the reliable bonding of the following material combinations of joint partners: plastic/plastic, plastic/glass, glass/glass.

17. Use according to Claim 16 for the operationally reliable bonding of SMD-compatible opto-electronic components for the automobile sector.

## Revendications

1. Composant optoélectronique doté d'un émetteur ou récepteur optoélectronique (1), d'une couche transparente (5) appliquée sur l'émetteur ou récepteur et encapsulant ce dernier et d'un élément optique (7) disposé au-dessus de la couche transparente,
**caractérisé en ce que**
le composant optoélectronique présente un boîtier (3) doté d'un creux,
**en ce que** l'émetteur ou récepteur optoélectronique est monté dans le creux et **en ce que** la couche transparente est disposée dans le creux et
**en ce que** l'élément optique est collé sur la couche transparente par une couche d'adhésif (6) en résine à un composant différente de la couche transparente.

2. Composant selon la revendication 1, dans lequel la couche d'adhésif (6) est formée d'une résine époxy à durcissement cationique amorcé par UV ou la lumière.

3. Composant selon les revendications 1 ou 2, dans lequel la couche d'adhésif (6) a une température de transition vitreuse supérieure à 100 °C.

4. Composant selon l'une des revendications 1 à 3, dans lequel la couche d'adhésif (6) a un indice de réfraction supérieur à 1,5.

5. Composant selon l'une des revendications 1 à 4, dans lequel la couche transparente (5) et l'élément optique (7) sont constitués de verre, de polyacrylate, de polyuréthane ou d'une matière de moulage en résine époxy.

6. Composant selon l'une des revendications 1 à 5, dans lequel l'élément optique (7) présente sur la surface de jonction une topologie de surface différente de celle d'une surface plane.

7. Composant selon l'une des revendications 1 à 6, dans lequel une denture (8) est formée sur le côté de jonction de l'élément optique (5).

8. Composant selon la revendication 7, dans lequel la denture (8) est formée de creux ou de saillies et présente en particulier la forme de structures en boutons ou en tourillons formées sur l'élément optique (5).

9. Composant selon l'une des revendications 1 à 8, dans lequel des éléments d'écartement (8) sont disposés entre l'élément optique (5) et la couche transparente (6) et sont formés de préférence sur l'élément optique.

10. Procédé de collage précis de pièces transparentes (5, 7) d'un composant optoélectronique, lequel procédé présente les étapes qui consistent à:
- appliquer une mince couche de résine (6) en résine époxy durcissable cationiquement sur une surface d'une des pièces transparentes à coller,
- placer et aligner une autre pièce transparente sur la couche de résine,
- appliquer un rayonnement UV ou lumineux pour durcir (micialement) la couche de résine,
- durcir complètement la couche de résine, dans leguel procedé
- la couche de résine est différente de la pièce transparente et de l'autre pièce transparente,
- l'une des pièces transparentes est une couche transparente (5) appliquée au-dessus d'un émetteur ou récepteur optoélectronique (1) et qui encapsule ce dernier est disposée dans un creux d'un boîtier du composant optoélectronique (3) dans lequel l'émetteur ou récepteur est monté et
- l'autre pièce transparente est un élément optique (7).

11. Procédé selon la revendication 10, dans lequel une des pièces (5) à coller est préparée par durcissement d'une pâte de coulée, la pâte de coulée étant durcie avant que la couche de résine (6) soit appliquée et que l'autre pièce transparente (7) soit appliquée et alignée.

12. Procédé selon l'une des revendications 10 à 11, dans lequel l'application d'un rayonnement UV s'effectue par éclair UV et le durcissement s'effectue à une température supérieure à 120 °C.

13. Procédé selon l'une des revendications 10 à 12, dans lequel on utilise pour la couche de résine (6) une résine époxy qui présente comme composant principal un diglycidyléther de bisphénol A et un photo-initiateur qui libère les cations.

14. Procédé selon la revendication 13, dans lequel on utilise une résine époxy qui comprend les composants suivants, donnés en pourcentage en poids:
- de 80 à 99 % de résine époxy difonctionnelle ou polyfonctionnelle,
- de 0 à 10 % de résine époxy monofonctionnelle,
- de 0 à 19 % d'éther de vinyle,
- de 0 à 10 % d'alcool aliphatique ou cycloaliphatique,
- de 0 à 5 % d'agent adtrésif
et
- de 0,1 à 5 % d'un photo-initiateur de durcissement cationique.

15. Utilisation d'une résine époxy à durcissement cationique avec un diglycidyléther de bisphénol A comme composant principal pour le collage en position précise d'une couche transparente (5) appliquée au-dessus d'un émetteur ou récepteur optoélectronique (1) et encapsulant ce dernier, qui est disposée dans un creux d'un boîtier d'un composant optoélectronique (8) dans laquelle l'émetteur ou récepteur est monté, avec un autre élément optique (7), par exemple un miroir ou une lentille.

16. Utilisation selon la revendication 15, pour le collage fiable des combinaisons suivantes de matériaux de partenaires de jonction: matière synthétique/matière synthétique, matière synthétique/verre, verre/verre.

17. Utilisation selon la revendication 16, pour le collage fiable de composants optoélectroniques à capacité SMD dans le secteur de l'automobile.
